# EUROPEAN PATENT APPLICATION

(11) **EP 4 333 580 A1**
(43) Date of publication of application: **06.03.2024**
(21) Application number: 22819560.8
(22) Date of filing: 08.06.2022
(51) Int. Cl.: H05K 7/20, H05K 9/00

(54) **HEAT DISSIPATION MEMBER AND ELECTRONIC DEVICE**

(30) Priority: 10.06.2021 CN 202110649797
(71) Applicant: Huawei Technologies Co., Ltd., Shenzhen, Guangdong 518129 (CN)
(72) Inventor: JIN, Linfang, Shenzhen, Guangdong 518129 (CN); SUN, Yalong, Guangzhou, Guangdong 510641 (CN); TANG, Yong, Guangzhou, Guangdong 510641 (CN); LIU, Yonglu, Shenzhen, Guangdong 518129 (CN)
(74) Representative: Goddar, Heinz J.
(86) International application number: PCT/CN2022/097617
(87) International publication number: WO 2022/257963

(57) **Abstract**

This application provides a heat dissipation element and an electronic device including the heat dissipation element. The heat dissipation element includes a housing and a cooling medium located on an inner side of the housing. The housing is sealed to form a sealed cavity, and the cooling medium is located in the sealed cavity. The housing includes a first layer and a second layer. The first layer and the second layer are stacked. The second layer is closer to the cooling medium than the first layer. The first layer and the second layer are made of different materials, and a material for the second layer includes a metal. An accommodation groove is provided on a part of the housing, the accommodation groove is recessed from an outer surface of the housing to the second layer, and the accommodation groove is for accommodating a heating element. The heat dissipation element provided in this application is bendable and deformable, and equivalent thermal resistance of the housing in the heat dissipation element is small, which helps improve heat dissipation performance of the heat dissipation element.

## Description

This application claims priority to Chinese Patent Application No. 202110649797.8, filed with the China National Intellectual Property Administration on June 10, 2021 and entitled "HEAT DISSIPATION ELEMENT AND ELECTRONIC DEVICE", which is incorporated herein by reference in its entirety.

### TECHNICAL FIELD

Embodiments of this application relate to the field of electronic device technologies, and in particular, to a heat dissipation element and an electronic device.

### BACKGROUND

At present, heat dissipation elements such as heat pipes or vapor chambers are widely used in smartphones, notebook computers, and other electronic devices. However, for phase-change heat transfer elements with metal sealed bodies like copper, steel, or titanium, vapor chambers or heat pipes cannot be bent at will, failing to meet heat dissipation requirements of flexible electronic devices such as watches, smart glasses, and flexible displays.

### SUMMARY

Embodiments of this application provide a heat dissipation element and an electronic device including the heat dissipation element. The heat dissipation element provided in this application has good flexibility, which can implement free bending of the heat dissipation element. In addition, equivalent thermal resistance of a housing in the heat dissipation element is small, which helps improve heat dissipation performance of the heat dissipation element.

According to a first aspect, this application provides a heat dissipation element. The heat dissipation element is configured to dissipate heat of a heating element. The heat dissipation element includes a housing and a cooling medium located on an inner side of the housing. The housing is sealed to form a sealed cavity, and the cooling medium is located in the sealed cavity. For example, the sealed cavity is a vacuum cavity. The cooling medium may be, but is not limited to, one or more of water, ethanol, acetone, methanol, or another refrigerant.

In an embodiment of this application, a heat dissipation principle of the heat dissipation element is as follows: Heat generated by the heating element (heat source) is conducted to the housing, and the cooling medium in the sealed cavity in the housing is heated in a low-vacuum environment and is then vaporized. In this case, the vaporized cooling medium rapidly expands and fills up the entire sealed cavity. When entering a cooling zone, the vaporized cooling medium condenses into a liquid phase, and the cooling medium of the liquid phase flows back to an end close to the heating element. This process is repeated in the sealed cavity, so that the heat dissipation element dissipates heat of the heating element.

The housing may be bent and deformed. The housing includes a first layer and a second layer. The first layer and the second layer are stacked. The second layer is closer to the cooling medium than the first layer. The first layer and the second layer are made of different materials. For example, a material for the first layer includes a polymer, and a material for the second layer includes a metal. The polymer, also referred to as a high-molecular compound, is a compound with a relative molecular mass of more than 10000 that is formed by mainly covalent binding of a plurality of atoms or atomic groups. The polymer material mentioned in this application includes, but is not limited to, polyimide, polydimethylsiloxane, nylon, or polyethylene terephthalate.

In this embodiment, the housing includes the first layer and the second layer that are stacked. The housing has good flexibility by using a composite layer structure of the polymer and the metal, so that the housing can be freely bent or folded, which ensures normal flowing of the cooling medium inside when the housing is in a bent state.

In addition, the second layer in the housing is made of the metal material, so that the second layer has extremely high compactness, which meets a requirement of air tightness of phase-change heat transfer of the cooling medium inside the housing. Moreover, thermal conductivity of the metal material is high, which helps improve heat transfer efficiency of the housing, and further improve heat dissipation performance of the heat dissipation element for the heating element.

In an embodiment of this application, the housing is flexible. The housing may be bent by 180 degrees under a condition of a small bending radius (less than 2 mm). Alternatively, the housing may be repeatedly bent under a condition of a large bending radius (greater than or equal to 2 mm), and there are no cracks before and after bending.

In some embodiments, the second layer is copper foil or aluminum foil. The housing not only has good flexibility, but also has high thermal conductivity, which helps improve overall performance of the housing. In another embodiment, the second layer may be made of another metal, for example, steel or an alloy. A specific material for the second layer is not limited in this application. The first layer is made of a bendable material like a polyimide film (polyimide film, PI), a polypropylene film, a nylon film, a graphite film, or a graphene film. For example, the first layer is a nylon layer, and the second layer is copper foil. Alternatively, the first layer is a nylon layer, and the second layer is aluminum foil. Alternatively, the first layer is a polyimide film, and the second layer is copper foil.

In this embodiment, when a material for the first layer includes a polymer, the first layer is a polymer film layer; and when a material for the second layer includes a metal, the second layer is metal foil, to improve overall flexibility of the housing. A specific material, thickness, and the like for the first layer or the second layer are not limited in this application, but can be limited by a person skilled in the art according to an actual requirement.

In a possible implementation, an accommodation groove is provided on a part of the housing, and the accommodation groove is recessed from an outer surface of the housing to the second layer. That the accommodation groove is recessed to the second layer indicates that a groove depth of the accommodation groove is from an upper surface of the first layer to an upper surface of the second layer. It may be understood that a bottom wall of the accommodation groove is a surface that is of the second layer and that is close to the first layer. The accommodation groove is for accommodating the heating element. The heating element is in direct or indirect contact with the second layer.

In this embodiment, the accommodation groove is recessed from the outer surface of the housing to the second layer, the second layer is made of the metal material, a groove wall of the accommodation groove is the second layer made of the metal material, and the heating element is in direct or indirect contact with the second layer made of the metal material in the housing. As the metal has good thermal conductivity, introduction of high thermal resistance by the heating element to the partial polymer layer of the housing is avoided, which greatly reduces equivalent thermal resistance of the housing, thereby improving heat dissipation performance of the heat dissipation element for the heating element. In addition, the housing and the heating element overlap at least partially in thickness, which also helps reduce the thickness.

In some embodiments, an accommodation groove is provided on an outer surface of the housing, a bottom wall of the accommodation groove is the second layer, and the second layer is made of a metal material. The metal structure of the inner layer of the housing is exposed, and the exposed metal structure may be used for grounding. How the exposed metal structure of the housing is grounded is not limited in this application, but can be designed by a person skilled in the art according to an actual requirement. For example, the exposed metal structure of the housing may be electrically connected to a ground layer of a circuit board.

In addition, the second layer in the housing is made of the metal material, so that the second layer has extremely high compactness, which meets a requirement of air tightness of phase-change heat transfer of the cooling medium inside the housing. Moreover, thermal conductivity of the metal material is high, which helps improve heat transfer efficiency of the housing, and further improve heat dissipation performance of the heat dissipation element for the heating element.

In a possible implementation, the first layer is an outermost layer of the housing, and the second layer is in contact with the cooling medium. It may be understood that an innermost layer of the housing is made of a metal material. For example, a material for the first layer includes a polymer, a material for the second layer includes a metal, and thermal conductivity of the material for the first layer is less than thermal conductivity of the material for the second layer.

In this embodiment, the innermost layer of the housing is made of the metal material, to isolate the first layer made of the polymer from the cooling medium, so that penetration of gaseous or liquid small molecules of the cooling medium into the first layer is avoided in a long-term use process of the heat dissipation element, which helps prolong a service life of the heat dissipation element.

In a possible implementation, the housing further includes an adhesive layer. The adhesive layer is bonded between the second layer and the first layer. The adhesive layer may be solid glue or liquid glue. A material for the adhesive layer is not limited in this application.

In this embodiment, the first layer and the second layer are fixedly connected by using the adhesive layer. In another embodiment, the first layer and the second layer may be formed by electroplating, electroless plating, spraying, or injection molding. In some other embodiments, the second layer and the first layer may be laminated by vacuum hot rolling, vacuum cold rolling, vacuum diffusion welding, or the like, to form a composite layer. A specific formation process of the housing is not limited in this application, but can be designed by a person skilled in the art according to an actual requirement.

In a possible implementation, the housing further includes a third layer, and the third layer is located between the first layer and the second layer. A material for the third layer includes a polymer or a metal. The material for the third layer is different from the material for the adjacent first layer or second layer.

For example, the second layer is made of a metal material, the third layer is made of a plastic material, and the first layer is made of a metal material. When the material for the first layer includes a metal, the metal material for the first layer may be the same as the metal material for the second layer, or may be different from the metal material for the second layer. This is not strictly limited in this application. Alternatively, the second layer is made of a metal material, the third layer is made of a first plastic material, the first layer is made of a second plastic material, and the first plastic material is different from the second plastic material.

In this embodiment, the second layer is the innermost structure of the housing, and the second layer is made of the metal material to isolate another structure that is of the housing and that is made of a polymer from the cooling medium, for example, isolate the third layer from the cooling medium, so that penetration of gaseous or liquid small molecules of the cooling medium into the first layer is avoided in a long-term use process of the heat dissipation element, which helps prolong a service life of the heat dissipation element.

It may be understood that, in this embodiment, the accommodation groove is recessed from the outer surface of the housing to a metal layer (the second layer) of the innermost layer of the housing. In another embodiment, based on a layer structure design of the housing, the accommodation groove may alternatively be recessed from the outer surface of the housing to another layer structure of the housing. This is not strictly limited in this application. A person skilled in the art can design a groove depth of the accommodation groove according to an actual situation of the housing, to improve heat dissipation performance of the heat dissipation element for the heating element.

In a possible implementation, the housing further includes a third layer, the third layer is located on a side that is of the second layer and that is away from the first layer, and a material for the third layer includes a polymer. In other words, the second layer is located between the first layer and the third layer. The first layer may be made of a metal material or may be made of a polymer material. This is not limited in this application. When the material for the first layer includes a metal, the metal material for the first layer may be the same as the metal material for the second layer, or may be different from the metal material for the second layer. This is not strictly limited in this application.

In this embodiment, the second layer (the metal layer) is located in a middle layer of the housing, and the accommodation groove is recessed from the outer surface of the housing to the second layer of the housing. It may be understood that a person skilled in the art can design a groove depth of the accommodation groove according to a layer structure of the housing, so that a layer structure of a bottom wall of the accommodation groove is made of a metal material, to improve heat dissipation performance of the heat dissipation element for the heating element.

In another embodiment, the housing may further include a fourth layer. The fourth layer is also located on a side between the first layer and the second layer, and a material for the fourth layer is different from the material for the third layer. In this case, the third layer may alternatively be made of a metal material, and the fourth layer is made of a polymer material. It may be understood that a specific quantity of layers of the housing and a specific material for each layer are not limited in this application, but can be designed by a person skilled in the art according to an actual requirement.

In a possible implementation, the housing includes a first housing, a second housing, and a packaging edge. The packaging edge is connected between the first housing and the second housing in a sealed manner. A material for the packaging edge includes a material for an innermost structure of the first housing and a material for an innermost structure of the second housing.

In this embodiment, the innermost layer of the housing is made of a metal material, and the first housing and the second housing may be packaged by soldering. In this case, the material for the packaging edge is a metal material. It may be understood that the packaging edge is solder for soldering the first housing and the second housing. The material for the packaging edge may be, but is not limited to, copper paste, aluminum paste, or the like.

In some other embodiments, when the innermost layer of the housing is made of a polymer material, the first housing and the second housing may be packaged by hot pressing. In this case, the material for the packaging edge is a polymer material.

In some other embodiments, an adhesive is used for the packaging edge. It may be understood that the first housing and the second housing are in a sealed connection in an adhesion manner. The adhesive is a technology in which surfaces of homogeneous or heterogeneous substances are bonded together, and is characterized by continuous stress distribution, light weight, sealing, low temperature of most processes, and the like. A specific type of the adhesive is not limited in this application. A person skilled in the art can select a proper adhesive according to an actual requirement. For example, the adhesive may be, based on a form, a water-soluble adhesive, a water-emulsion adhesive, a solvent-based adhesive, or a solid-state adhesive.

In a possible implementation, a packaging temperature at which the first housing, the second housing, and the packaging edge are packaged to form the sealed cavity is less than or equal to 300 degrees. For example, the first housing and the second housing form the sealed cavity by using a hot pressing, soldering, or adhesion process.

In this embodiment, an excessively high packaging temperature is not suitable for the housing. For example, the packaging temperature is less than or equal to 300 degrees, to avoid deformation or decomposition of the first layer made of a polymer material due to the excessively high packaging temperature, thereby improving packaging reliability of the housing. In addition, an excessively low packaging temperature is not suitable for the housing, to avoid a sealing failure of the first housing and the second housing caused by low temperature. A specific packaging temperature for the first housing and the second housing is not limited in this application, but can be designed by a person skilled in the art according to an actual requirement.

It may be understood that a specific process and process parameter for packaging the first housing and the second housing are not limited in this application, but can be designed by a person skilled in the art according to an actual requirement. For example, the first housing and the second housing may be connected by using a hot pressing, adhesion, or soldering process, to avoid deformation of the housing during vacuumizing and working.

In a possible implementation, the heat dissipation element further includes a liquid-absorbing layer and a channel layer, and the liquid-absorbing layer and the channel layer are accommodated in the sealed cavity. The liquid-absorbing layer and the channel layer are stacked, and the liquid-absorbing layer is closer to the accommodation groove than the channel layer. The liquid-absorbing layer is closer to the accommodation groove than the channel layer, that is, the liquid-absorbing layer is closer to the heat source, and is configured to absorb the liquid cooling medium to the housing close to a side of the accommodation groove. The channel layer is configured for the cooling medium in a gas phase or a liquid phase to flow.

In an embodiment of this application, the liquid-absorbing layer can generate a capillary force to transport the cooling medium, and the cooling medium in the liquid phase flows back to an end close to the heating element with the help of an adsorption force of the liquid-absorbing layer. This process is repeated in the sealed cavity to dissipate heat of the heating element, to complete an entire power cycle and then complete a thermodynamic cycle.

In some embodiments, the liquid-absorbing layer may be a porous liquid-absorbing core. A material for the liquid-absorbing layer may be, but is not limited to, a bendable hydrophilic material like copper, modified hydrophilic nylon, carbon fiber, graphene fiber, graphene oxide, or polypropylene. A liquid-absorbing layer structure may be formed by 1 to 10 layers of two-dimensional woven mesh, or may be formed by a three-dimensional woven belt, or may be formed by a composite structure of two-dimensional woven mesh and a three-dimensional woven belt. This is not limited in this application. For example, the liquid-absorbing layer is a copper mesh liquid-absorbing core.

In some embodiments, the channel layer may be macroporous mesh, or may be a flexible sheet having a microchannel structure, or may be a microstructure that is bonded to an inner side of the housing by curing polymer precursor liquid glue. For example, the channel layer may be manufactured through laser cutting, wire-electrode cutting, etching, flexible sheet stamping, or a like process. The channel layer is a nylon mesh vapor channel. The channel layer may be connected to the liquid-absorbing layer and the inner side of the housing through a process, for example but not limited to, adhesion, hot pressing, or sintering.

A quantity of layers of the liquid-absorbing core or the channel layer is not limited in this application, but can be designed by a person skilled in the art according to an actual situation. For example, the liquid-absorbing layer is a three-layer super-hydrophilic copper mesh liquid-absorbing core, and the channel layer is single-layer 20-mesh nylon mesh.

In embodiments provided in this application, specific materials for the liquid-absorbing layer and the channel layer are not limited, but can be designed by a person skilled in the art according to an actual requirement. The channel layer can support the housing, to avoid deformation of the housing under an external force, which causes the liquid-absorbing layer to be flattened and therefore the heat dissipation element to fail.

In a possible implementation, the heat dissipation element further includes a capillary structure and a medium channel. Both the capillary structure and the medium channel are located in the sealed cavity. The capillary structure is fixed on the first housing, and the accommodation groove is located on the first housing. One end of the medium channel abuts against the second housing, and the other end of the medium channel overlaps the capillary structure.

In an embodiment of this application, the capillary structure is fixed on the first housing, and the accommodation groove is located on the first housing. In other words, the capillary structure is close to the heating element. The capillary structure can generate a capillary force to transport the cooling medium, and the cooling medium in the liquid phase flows back to an end close to the heating element with the help of an adsorption force of the capillary structure. This process is repeated in the sealed cavity to dissipate heat of the heating element, to complete an entire power cycle and then complete a thermodynamic cycle.

In addition, the medium channel abuts against the housing. The medium channel can be configured to resist deformation of the heat dissipation element caused by an internal and external atmospheric pressure difference and another external force, to maintain a shape of the housing and avoid deformation of the housing under an external force, which causes the capillary structure to be flattened and therefore the heat dissipation element to fail. For example, the medium channel is formed by a plurality of support columns disposed at intervals, and a channel between the support columns is a cooling medium channel and/or forms the capillary structure.

In some embodiments, the medium channel is fixed on the innermost side of the housing in an adhesion manner. A specific manner of forming the medium channel is not limited in this application, but can be designed by a person skilled in the art according to an actual situation. For example, the medium channel is a microstructure formed by curing polydimethylsiloxane (polydimethylsiloxane, PDMS).

In a possible implementation, the heat dissipation element further includes a capillary structure and a medium channel. Both the capillary structure and the medium channel are located in the sealed cavity. One end of the capillary structure is connected to the first housing, and the other end is connected to the second housing. The medium channel is connected to the capillary structure, one end of the medium channel is connected to the first housing, and the other end is connected to the second housing. It may be understood that the capillary structure is embedded in the medium channel.

In this embodiment, the capillary structure is embedded in the medium channel, the capillary structure and the medium channel form an integral structure, and the capillary structure and the medium channel are reused in a thickness direction of the housing, which reduces a thickness of the entire heat dissipation element, thereby reducing a thickness of an entire electronic device.

In a possible implementation, there are a plurality of accommodation grooves, and the plurality of accommodation grooves are provided at intervals. Both the first housing and the second housing are provided with the accommodation grooves.

In this embodiment, the capillary structure is embedded in the medium channel, and the capillary structure is connected to both the first housing and the second housing. The cooling medium in the liquid phase can flow back to the inner side of the first housing or the inner side of the second housing with the help of an adsorption force of the capillary structure, to effectively dissipate heat of the heating element in the accommodation groove of the first housing and the heating element in the accommodation groove of the second housing, to complete an entire power cycle and then complete a thermodynamic cycle.

According to a second aspect, this application further provides an electronic device. The electronic device includes a heating element and the foregoing heat dissipation element. The electronic device may be a bendable product like a wearable device, a mobile phone, a tablet computer, a notebook computer, an audio player, or an on-board device. This is not limited in this application. The wearable device may be a band, a watch, augmented reality (augmented reality, AR) glasses, virtual reality (virtual reality, VR) glasses, a helmet display, or the like. At least a part of a structure of the heating element is accommodated in the accommodation groove, and the heat dissipation element is configured to dissipate heat of the heating element. The heating element may be, but is not limited to, a system on chip (system on chip, SOC), a sensor, or the like.

In this embodiment, the accommodation groove for accommodating the heating element is provided on the part of the housing, the accommodation groove is recessed from the outer surface of the housing to the second layer, the second layer is made of the metal material, and the heating element is in direct or indirect contact with the second layer made of the metal material in the housing. As the metal has good thermal conductivity, introduction of high thermal resistance by the heating element to the partial polymer layer of the housing is avoided, which greatly reduces equivalent thermal resistance of the housing, thereby improving heat dissipation performance of the heat dissipation element for the heating element. In addition, the housing and the heating element overlap at least partially in thickness, which also helps reduce the thickness.

In a possible implementation, the electronic device includes a first outer shell and a second outer shell that are connected to each other. The second outer shell is capable of being bent relative to the first outer shell. The heating element is accommodated in the first outer shell. The heat dissipation element includes a first section and a second section that are integrally formed. The first section is accommodated in the first outer shell. The second section is accommodated in the second outer shell, and the second section is capable of being bent relative to the first section. It may be understood that the heat dissipation element covers the heating element, and a surface area of the heat dissipation element is greater than a surface area of the heating element.

In this embodiment, the heat dissipation element not only covers the heating element, but also is disposed in the second outer shell. This effectively increases a heat dissipation area of the heat dissipation element, thereby improving heat dissipation performance of the heat dissipation element for the heating element.

The second section is capable of being bent relative to the first section. When the second outer shell is bent relative to the first outer shell, the second section inside the second outer shell is also bent synchronously relative to the first section, so that the second section and the second outer shell are deformed synchronously.

In a possible implementation, the electronic device further includes a third outer shell. The third outer shell is located on a side that is of the first outer shell and that is away from the second outer shell, and the third outer shell is capable of being bent relative to the first outer shell. The heat dissipation element further includes a third section, and the third section is accommodated in the third outer shell. The third section is connected to an end that is of the first section and that is away from the second section. The third section and the first section are integrally formed, and the third section is capable of being bent relative to the first section.

In this embodiment, the heat dissipation element is not only located inside the first outer shell and the second outer shell, but also extends inside the third outer shell. This further increases a heat dissipation area of the heat dissipation element, thereby further improving heat dissipation performance of the heat dissipation element. In addition, the third section is bendable relative to the first section, so that the third outer shell of the outer shell can be bent relative to the first outer shell, and further both the second outer shell and the third outer shell can be bent relative to the first outer shell.

In this embodiment, an example in which the heat dissipation element is located in the first outer shell, the second outer shell, or the third outer shell is used for description. In another embodiment, the heat dissipation element may alternatively be located only in the first outer shell and the second outer shell; or the heat dissipation element may alternatively be located only in the first outer shell and the third outer shell. A person skilled in the art can set, according to an actual requirement of the electronic device, the heat dissipation element to extend from the first outer shell to the second outer shell or the third outer shell. This is not limited in this application. For example, when the second outer shell is detachably connected to the first outer shell, the heat dissipation element may be located only in the first outer shell and the third outer shell.

In a possible implementation, the electronic device further includes a thermal interface layer, the thermal interface layer is connected between the second layer and the heating element, and a material for the thermal interface layer includes a thermal interface material. The thermal interface material, also referred to as an interface heat conduction material, has good thermal conductivity, and not only effectively transfers heat, but also can reduce thermal resistance of the thermal interface material. In addition, the thermal interface material has a tolerance absorption capability in an order of size. A specific material for the thermal interface material is not limited in this application, but can be designed by a person skilled in the art according to an actual requirement. For example, the thermal interface material includes a phase-change heat-conducting material, a carbon fiber heat-conducting pad, or the like.

In this embodiment, the thermal interface layer is disposed between the heating element and the heat dissipation element. The thermal interface layer can absorb a dimensional tolerance between the heating element and the heat dissipation element, and fill micropores and uneven voids formed when the heating element and the heat dissipation element are combined or in contact. In this way, heat generated by the heating element is effectively transferred to the heat dissipation element, and heat transfer resistance is reduced, thereby improving heat dissipation performance of the heat dissipation element for the heating element.

In this embodiment, an example in which heat generated by the heating element is transferred to the heat dissipation element through the thermal interface layer, that is, the heat dissipation element is in indirect contact with the heating element is used for description. In another embodiment, no thermal interface layer may be disposed between the heat dissipation element and the heating element, and heat generated by the heating element is directly transferred to the heat dissipation element. This is not limited in this application. It may be understood that a surface of the heat dissipation element may be directly or indirectly connected to the heating element, to effectively conduct and diffuse heat generated by the heating element.

In a possible implementation, the electronic device further includes a circuit board and a shielding cover. The heating element is mounted on the circuit board. The shielding cover is disposed around a periphery of the heating element and forms, with the circuit board, shielding space. The heating element is accommodated in the shielding space.

In this embodiment, the shielding cover is disposed on an outer side of the heating element, and the shielding cover surrounds the heating element, to prevent the heating element from being affected by an external electromagnetic field, thereby improving an anti-electromagnetic interference capability of the heating element.

In a possible implementation, a first thermal interface layer and a second thermal interface layer are included between the heating element and the heat dissipation element. The first thermal interface layer is located between the shielding cover and the heating element. The second thermal interface layer is located between the heat dissipation element and the shielding cover, and both the first thermal interface layer and the second thermal interface layer are made of the thermal interface material. The thermal interface materials for the first thermal interface layer and the second thermal interface layer may be the same or may be different. This is not limited in this application.

In this embodiment, the first thermal interface layer is disposed between the shielding cover and the heating element, and the second thermal interface layer is disposed between the shielding cover and the heat dissipation element. The first thermal interface layer can absorb a dimensional tolerance between the heating element and the shielding cover, and fill micropores and uneven voids formed when the heating element and the shielding cover are combined or in contact. The second thermal interface layer can absorb a dimensional tolerance between the heat dissipation element and the shielding cover, and fill micropores and uneven voids formed when the heat dissipation element and the shielding cover are combined or in contact. In this way, heat transfer resistance is reduced, thereby improving heat dissipation performance of the heat dissipation element for the heating element.

### BRIEF DESCRIPTION OF DRAWINGS

To describe technical solutions in embodiments of this application or in the background, the accompanying drawings for describing embodiments of this application or the background are described below.
FIG. 1 is a schematic diagram of a structure of an electronic device according to an embodiment of this application;
FIG. 2 is a top view of the electronic device shown in FIG. 1 in another state;
FIG. 3 is a schematic diagram of a partial cross section of the electronic device shown in FIG. 2;
FIG. 4 is a schematic diagram of a structure of a heat dissipation element shown in FIG. 1;
FIG. 5 is a schematic explosive diagram of a partial structure of the heat dissipation element shown in FIG. 4;
FIG. 6 is a schematic diagram of a partial cross section of the heat dissipation element shown in FIG. 4 along a line A-A in a first embodiment;
FIG. 7 is a schematic diagram of a partial cross section of the heat dissipation element shown in FIG. 4 along the line A-A in a second embodiment;
FIG. 8 is a schematic diagram of a partial cross section of the heat dissipation element shown in FIG. 4 along the line A-A in a third embodiment;
FIG. 9 is a schematic diagram of a partial cross section of the heat dissipation element shown in FIG. 4 along the line A-A in a fourth embodiment;
FIG. 10 is a schematic diagram of a structure of a medium channel in FIG. 9 formed in an implementation;
FIG. 11 is a schematic diagram of a structure of the medium channel in FIG. 9 formed in another implementation; and
FIG. 12 is a schematic diagram of a partial cross section of the heat dissipation element shown in FIG. 4 along the line A-A in a fifth embodiment.

### DESCRIPTION OF EMBODIMENTS

The following describes embodiments of this application with reference to the accompanying drawings in embodiments of this application.

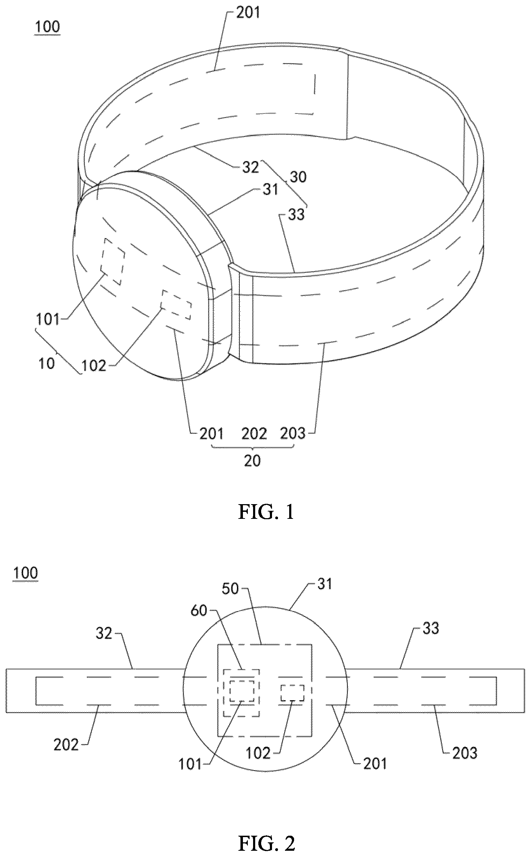

As shown in FIG. 1, an electronic device 100 includes a heating element 10, a heat dissipation element 20, and an outer shell 30. In a working process of the electronic device 100, the heating element 10 generates heat. The heat dissipation element 20 is configured to dissipate heat of the heating element 10. The heat dissipation element 20 may conduct, diffuse, or exchange heat generated by the heating element 10, to dissipate heat of the heating element 10, thereby preventing performance of the electronic device 100 from being affected by an excessively high temperature of the heating element 10. The outer shell 30 is configured to protect the heating element 10 and the heat dissipation element 20 that are located inside the outer shell 30. A specific material for the outer shell 30 is not limited in this application, but can be designed by a person skilled in the art according to an actual requirement.

In some embodiments, there are a plurality of heating elements 10. The plurality of heating elements 10 include a first heating element 101 and a second heating element 102 that are disposed at an interval. The heat dissipation element 20 cannot only dissipate heat of the first heating element 101, but also dissipate heat of the second heating element 102. A quantity, shape, or relative position of the heating elements 10 in FIG. 1 is merely an example. This is not limited in this application. For example, the first heating element 101 may be, but is not limited to, a system on chip (system on chip, SOC). In a narrow sense, the system on chip is core chip integration of an information system, which integrates key components of the system onto a chip. In a broad sense, the system on chip is a miniature system, and the system on chip may be a system into which functions of a processor, a memory, a power management chip, or the like are integrated. The second heating element 102 may be, but is not limited to, a sensor.

In some other embodiments, the heating element 10 may alternatively be a central processing unit (central processing unit, CPU) or a graphics processing unit (graphics processing unit, GPU). For example, the central processing unit in operation generates a large amount of heat. The heat dissipation element 20 may dissipate heat of the central processing unit, to prevent working performance of the electronic device 100 from being affected by an excessively high temperature of the central processing unit. It may be understood that a specific structure or form of the first heating element 101 or the second heating element 102 is not limited in this application, but can be designed by a person skilled in the art according to an actual requirement of the electronic device 100.

Refer to FIG. 1 and FIG. 2. FIG. 2 is a top view of the electronic device 100 shown in FIG. 1 in another state. The outer shell 30 includes a first outer shell 31, a second outer shell 32, and a third outer shell 33. The first outer shell 31 is connected between the second outer shell 32 and the third outer shell 33. The third outer shell 33 is located on a side that is of the first outer shell 31 and that is away from the second outer shell 32. The second outer shell 32 is capable of being bent relative to the first outer shell 31. The third outer shell 33 is capable of being bent relative to the first outer shell 31. For example, materials for both the second outer shell 32 and the third outer shell 33 are flexible materials, and both the second outer shell 32 and the third outer shell 33 can be deformed.

As shown in FIG. 1, the second outer shell 32 and the third outer shell 33 are bent relative to the first outer shell 31. In this case, the electronic device 100 is in a bent state. As shown in FIG. 2, the second outer shell 32 and the third outer shell 33 are unbent relative to the first outer shell 31, and an extension direction of the first outer shell 31, an extension direction of the second outer shell 32, and an extension direction of the third outer shell 33 are approximately the same. In this case, the electronic device 100 is in an unbent state.

In this embodiment, the second outer shell 32 and the third outer shell 33 can be deformed, and the second outer shell 32 and the third outer shell 33 are capable of being bent relative to the first outer shell 31 or unbent relative to the first outer shell 31, so that the electronic device 100 is in different states. In another embodiment, the electronic device 100 may be only in a bent state. When an extension direction of the second outer shell 32 is substantially different from an extension direction of the first outer shell 31, or an extension direction of the third outer shell 33 is substantially different from an extension direction of the first outer shell 31, the electronic device 100 may be considered to be in the bent state.

It may be understood that when the electronic device 100 is in the bent state, different bending angles may be formed between the second outer shell 32 and the first outer shell 31 or between the third outer shell 33 and the first outer shell 31. For example, when the electronic device 100 is smart glasses, the second outer shell 32 and the third outer shell 33 are equivalent to two glasses leg parts of the smart glasses, and the first outer shell 31 is equivalent to a glasses frame part of the smart glasses. In this case, the second outer shell 32 and the third outer shell 33 are separately bent relative to the first outer shell 31.

In some other embodiments, the second outer shell 32 is fixed relative to the first outer shell 31, and the third outer shell 33 is capable of being bent relative to the first outer shell 31. Alternatively, the third outer shell 33 is fixed relative to the first outer shell 31, and the second outer shell 32 is capable of being bent relative to the first outer shell 31. It may be understood that at least one of the second outer shell 32 or the third outer shell 33 is capable of being bent relative to the first outer shell 31. This is not limited in this application, but can be designed by a person skilled in the art according to an actual requirement of the electronic device 100.

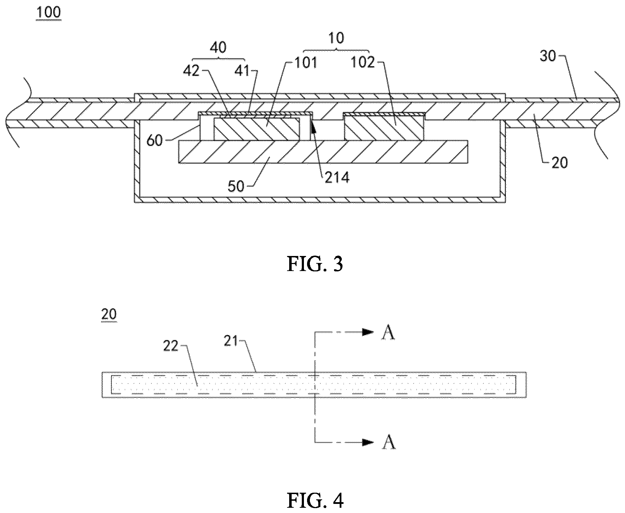

Refer to FIG. 2 and FIG. 3. FIG. 3 is a schematic diagram of a partial cross section of the electronic device 100 shown in FIG. 2. The heat dissipation element 20 includes a first section 201 and a second section 202 that are integrally formed. The first section 201 is accommodated in the first outer shell 31. The second section 202 is accommodated in the second outer shell 32, and the second section 202 is capable of being bent relative to the first section 201. The heating element 10 is accommodated in the first outer shell 31, and a projection of the heat dissipation element 20 covers a projection of the heating element 10. It may be understood that the heat dissipation element 20 covers the heating element 10, and a surface area of the heat dissipation element 20 is greater than a surface area of the heating element 10.

In this embodiment, the heat dissipation element 20 not only covers the heating element 10, but also is disposed in the second outer shell 32. This effectively increases a heat dissipation area of the heat dissipation element 20, thereby improving heat dissipation performance of the heat dissipation element 20.

The second section 202 is capable of being bent relative to the first section 201. When the second outer shell 32 is bent relative to the first outer shell 31, the second section 202 inside the second outer shell 32 is also bent synchronously relative to the first section 201, so that the second section 202 and the second outer shell 32 are deformed synchronously.

In this embodiment, the second section 202 located inside the outer shell 30 is capable of being bent relative to the first section 201, so that the second outer shell 32 of the outer shell 30 can be bent relative to the first outer shell 31, thereby ensuring reliability of the electronic device 100. It may be understood that, when the second section 202 of the heat dissipation element 20 cannot be bent and deformed relative to the first section 201, the heat dissipation element 20 cannot be located in both the first outer shell 31 and the second outer shell 32 that are relatively bent, that is, the heat dissipation element 20 cannot be located in both the first outer shell 31 and the second outer shell 32.

In some embodiments, the heat dissipation element 20 further includes a third section 203. The third section 203 is accommodated in the third outer shell 33. The third section 203 is connected to an end that is of the first section 201 and that is away from the second section 202. The third section 203 is integrally formed with the first section 201. For example, the third section 203 is capable of being bent relative to the first section 201.

In this embodiment, the heat dissipation element 20 is not only located inside the first outer shell 31 and the second outer shell 32, but also extends inside the third outer shell 33. This further increases a heat dissipation area of the heat dissipation element 20, thereby further improving heat dissipation performance of the heat dissipation element 20. In addition, the third section 203 is bendable relative to the first section 201, so that the third outer shell 33 of the outer shell 30 can be bent relative to the first outer shell 31, and further both the second outer shell 32 and the third outer shell 33 can be bent relative to the first outer shell 31.

In this embodiment, an example in which the heat dissipation element 20 is located in the first outer shell 31, the second outer shell 32, or the third outer shell 33 is used for description. In another embodiment, the heat dissipation element 20 may alternatively be located only in the first outer shell 31 and the second outer shell 32; or the heat dissipation element 20 may alternatively be located only in the first outer shell 31 and the third outer shell 33. A person skilled in the art can set, according to an actual requirement of the electronic device 100, the heat dissipation element 20 to extend from the first outer shell 31 to the second outer shell 32 or the third outer shell 33. This is not limited in this application. For example, when the second outer shell 32 is detachably connected to the first outer shell 31, the heat dissipation element 20 may be located only in the first outer shell 31 and the third outer shell 33.

Still refer to FIG. 3. The electronic device 100 further includes a thermal interface layer 40. The thermal interface layer 40 is connected between the heat dissipation element 20 and the heating element 10, and a material for the thermal interface layer 40 includes a thermal interface material (thermal interface material, TIM). The thermal interface material, also referred to as an interface heat conduction material, has good thermal conductivity, and not only effectively transfers heat, but also can reduce thermal resistance of the thermal interface material. In addition, the thermal interface material has a tolerance absorption capability in an order of size. A specific material for the thermal interface material is not limited in this application, but can be designed by a person skilled in the art according to an actual requirement. For example, the thermal interface material includes a phase-change heat-conducting material, a carbon fiber heat-conducting pad, or the like.

In this embodiment, the thermal interface layer 40 is disposed between the heating element 10 and the heat dissipation element 20. The thermal interface layer 40 can absorb a dimensional tolerance between the heating element 10 and the heat dissipation element 20, and fill micropores and uneven voids formed when the heating element 10 and the heat dissipation element 20 are combined or in contact. In this way, heat generated by the heating element 10 is effectively transferred to the heat dissipation element 20, and heat transfer resistance is reduced, thereby improving heat dissipation performance of the heat dissipation element 20 for the heating element 10.

In this embodiment, an example in which heat generated by the heating element 10 is transferred to the heat dissipation element 20 through the thermal interface layer 40, that is, the heat dissipation element 20 is in indirect contact with the heating element 10 is used for description. In another embodiment, no thermal interface layer 40 may be disposed between the heat dissipation element 20 and the heating element 10, and heat generated by the heating element 10 is directly transferred to the heat dissipation element 20. This is not limited in this application. It may be understood that a surface of the heat dissipation element 20 may be directly or indirectly connected to the heating element 10, to effectively conduct and diffuse heat generated by the heating element 10.

Refer to FIG. 2 and FIG. 3. In some embodiments, the electronic device 100 further includes a circuit board 50 and a shielding cover 60. The heating element 10 is mounted on the circuit board 50. The circuit board 50 is accommodated in the first outer shell 31. The shielding cover 60 is disposed around a periphery of the first heating element 101, and forms, with the circuit board 50, shielding space. The first heating element 101 is accommodated in the shielding space. In FIG. 2 or FIG. 3, shapes, positions, sizes, or the like of the heating element 10, the circuit board 50, and the shielding cover 60 are merely examples. This is not limited in this application.

In this embodiment, the shielding cover 60 is disposed on an outer side of the first heating element 101, and the shielding cover 60 surrounds the first heating element 101, to prevent the first heating element 101 from being affected by an external electromagnetic field, thereby improving an electromagnetic interference capability of the first heating element 101.

In this embodiment, an example in which the shielding cover 60 is disposed around the periphery of the first heating element 101 is used for description. In another embodiment, the shielding cover 60 may be disposed around peripheries of both the first heating element 101 and the second heating element 102, or no shielding cover 60 is disposed around peripheries of both the first heating element 101 and the second heating element 102, which can be designed by a person skilled in the art according to an actual requirement of each heating element 10. This is not limited in this application.

As shown in FIG. 3, in some embodiments, a first thermal interface layer 41 and a second thermal interface layer 42 are included between the first heating element 101 and the heat dissipation element 20. Both the first thermal interface layer 41 and the second thermal interface layer 42 are made of thermal interface materials. The materials for the first thermal interface layer 41 and the second thermal interface layer 42 may be the same or may be different. This is not limited in this application. The first thermal interface layer 41 and the second thermal interface layer 42 are respectively located on two sides of the shielding cover 60. For example, the first thermal interface layer 41 is located between the shielding cover 60 and the heating element 10, and the second thermal interface layer 42 is located between the heat dissipation element 20 and the shielding cover 60.

In this embodiment, the first thermal interface layer 41 is disposed between the shielding cover 60 and the heating element 10, and the second thermal interface layer 42 is disposed between the shielding cover 60 and the heat dissipation element 20. The first thermal interface layer 41 can absorb a dimensional tolerance between the heating element 10 and the shielding cover 60, and fill micropores and uneven voids formed when the heating element 10 and the shielding cover 60 are combined or in contact. The second thermal interface layer 42 can absorb a dimensional tolerance between the heat dissipation element 20 and the shielding cover 60, and fill micropores and uneven voids formed when the heat dissipation element 20 and the shielding cover 60 are combined or in contact. In this way, heat transfer resistance is reduced, thereby improving heat dissipation performance of the heat dissipation element 20 for the heating element 10.

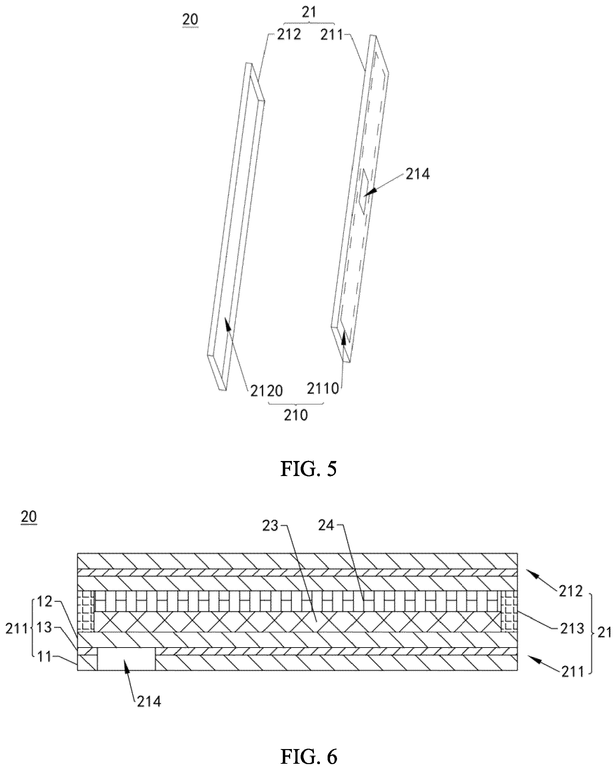

Refer to FIG. 4 and FIG. 5. FIG. 4 is a schematic diagram of a structure of the heat dissipation element 20 shown in FIG. 1. FIG. 5 is a schematic explosive diagram of a partial structure of the heat dissipation element 20 shown in FIG. 4. The heat dissipation element 20 includes a housing 21 and a cooling medium 22 located on an inner side of the housing 21. The housing 21 is sealed to form a sealed cavity, and the cooling medium 22 is located in the sealed cavity. For example, the sealed cavity is a vacuum cavity. The cooling medium 22 may be, but is not limited to, one or more of water, ethanol, acetone, methanol, or another refrigerant. In an embodiment of this application, an example in which the cooling medium 22 is water is used for description.

In this embodiment of this application, a heat dissipation principle of the heat dissipation element 20 is as follows: Heat generated by the heating element 10 (heat source) is conducted to the housing 21, and the cooling medium 22 in the sealed cavity in the housing 21 is heated in a low-vacuum environment and is then vaporized. In this case, the vaporized cooling medium 22 rapidly expands and fills up the entire sealed cavity. When entering a cooling zone, the vaporized cooling medium 22 condenses into a liquid phase, and the cooling medium 22 of the liquid phase flows back to an end close to the heating element 10. This process is repeated in the sealed cavity, so that the heat dissipation element 20 dissipates heat of the heating element 10.

In some embodiments, the housing 21 includes a first housing 211 and a second housing 212. The first housing 211 is connected to the second housing 212 in a sealed manner to form a sealed cavity 210, and the sealed cavity 210 is provided to accommodate the cooling medium 22 (not shown in the figure).

A manner of the sealed connection between the first housing 211 and the second housing 212 is not limited in this application. For example, the first housing 211 and the second housing 212 may be connected in a sealed manner by using a hot pressing, adhesion, or soldering process. A manner of the sealed connection between the first housing 211 and the second housing 212 is not limited in this application, but can be designed by a person skilled in the art according to an actual requirement.

In some embodiments, before the first housing 211 and the second housing 212 are packaged in a sealed manner, a sheet material of the first housing 211 and/or a sheet material of the second housing 212 is processed, for example, stamped, and then the first housing 211 and the second housing 212 are permanently deformed and form grooves, so that the sealed cavity 210 is formed after the first housing 211 and the second housing 212 are soldered. For example, the first housing 211 forms a first groove 2110, and the second housing 212 forms a second groove 2120. After the first housing 211 and the second housing 212 are packaged by using a hot pressing, adhesion, or soldering process, the first groove 2110 of the first housing 211 and the second groove 2120 of the second housing 212 are in communication and together form the sealed cavity 210 accommodating the cooling medium 22.

In this embodiment, the heat dissipation element 20 is flat and long, and has a large heat conduction area. For example, the heat dissipation element 20 is a heat pipe (heat pipe, HP), a loop heat pipe (loop heat pipe, LHP), or a vapor chamber (vapor chamber, VC). A principle of the heat pipe is similar to that of the vapor chamber. The cooling medium 22 in the sealed cavity is heated to change from a liquid phase to a gas phase, after heat absorption, the cooling medium 22 in the gas phase condenses into the liquid phase and releases heat, and a capillary force, gravity, and the like are used as transmission power of the cooling medium 22 in the liquid phase, to complete a phase change cycle of gas and liquid phases in hot and cold zones, thereby achieving efficient heat exchange by phase change latent heat, heat conduction, and convection.

In this embodiment, the heat dissipation element 20 is flat and long, has large heat dissipation and heat transmission areas, and can accommodate more cooling media 22 inside, thereby improving heat dissipation effect of the heat dissipation element 20.

Refer to FIG. 3 and FIG. 5. An accommodation groove 214 is provided on a part of the housing 21. An opening of the accommodation groove 214 is located on an outer surface of the housing 21. It may be understood that a bottom wall of the accommodation groove 214 is closer to the cooling medium 22 relative to the outer surface of the housing 21. The accommodation groove 214 is for accommodating the heating element 10. At least a part of a structure of the heating element 10 is accommodated in the accommodation groove 214. For example, the accommodation groove 214 is located on the first housing 211. In another embodiment, the accommodation groove 214 may alternatively be located on the second housing 212, or both the first housing 211 and the second housing 212 are provided with the accommodation grooves 214 for accommodating the heating element 10.

In this embodiment, the accommodation groove 214 for accommodating the heating element 10 is provided on the part of the housing 21, which reduces a heat transfer distance between the heating element 10 and the cooling medium 22 inside the housing 21, and therefore helps improve heat dissipation performance of the heat dissipation element 20 for the heating element 10. In addition, the housing 21 and the heating element 10 overlap at least partially in thickness, which also helps reduce the thickness.

In this embodiment, an example in which there is one accommodation groove 214 is used for description. One accommodation groove 214 may accommodate a single heating element 10, for example, the first heating element 101 or the second heating element 102. One accommodation groove 214 may alternatively accommodate a plurality of heating elements 10. For example, the first heating element 101 and the second heating element 102 are accommodated in a same accommodation groove 214. In another embodiment, there may alternatively be a plurality of accommodation grooves 214, and the plurality of accommodation grooves 214 are provided at intervals. For example, an example in which there are a plurality of accommodation grooves 214, and parts of structures of the first heating element 101 and the second heating element 102 are respectively accommodated in different accommodation grooves 214. In this application, a quantity, a depth, and the like of the accommodation grooves 214 are not limited, but can be designed by a person skilled in the art according to an actual situation.

A manner of forming the accommodation groove 214 in the housing 21 is not limited in this application. A person skilled in the art can remove a partial structure of the housing 21 in different manners according to an actual requirement, to form the accommodation groove 214. For example, the accommodation groove 214 may be obtained by removing a partial outer-layer structure of the housing 21 through laser, micro-milling, grinding, laser processing, or plasma etching.

FIG. 6 is a schematic diagram of a partial cross section of the heat dissipation element 20 shown in FIG. 4 along a line A-A in a first embodiment. The housing 21 includes a first layer 11 and a second layer 12. The first layer 11 and the second layer 12 are stacked. The second layer 12 is closer to the cooling medium 22 than the first layer 11. In other words, the second layer 12 is located on a side that is of the first layer 11 and that is close to the cooling medium 22. The first layer 11 and the second layer 12 are made of different materials, and a material for the second layer 12 includes a metal. For example, a material for the first layer 11 includes a polymer.

The polymer, also referred to as a high-molecular compound, is a compound with a relative molecular mass of more than 10000 that is formed by mainly covalent binding of a plurality of atoms or atomic groups. The polymer material mentioned in this application includes, but is not limited to, polyimide, polydimethylsiloxane, nylon, or polyethylene terephthalate.

In this embodiment, the housing 21 includes the first layer 11 and the second layer 12 that are stacked. The housing 21 has good flexibility by using a composite layer structure of the polymer and the metal, so that normal flowing of the cooling medium 22 inside the housing 21 can be ensured when the second section 202 or the third section 203 in the housing 21 is bent or folded relative to the first section 201.

In addition, the second layer 12 in the housing 21 is made of the metal material, so that the second layer 12 has extremely high compactness, which meets a requirement of air tightness of phase-change heat transfer of the cooling medium 22 inside the housing 21. Moreover, thermal conductivity of the metal material is high, which helps improve heat transfer efficiency of the housing 21, and further improve heat dissipation performance of the heat dissipation element 20 for the heating element 10.

In an embodiment of this application, the housing 21 is flexible. The housing 21 may be bent by 180° under a condition of a small bending radius (less than 2 mm). Alternatively, the housing 21 may be repeatedly bent under a condition of a large bending radius (greater than or equal to 2 mm), and there are no cracks before and after bending.

In some embodiments, the second layer 12 is copper foil or aluminum foil. The housing 21 not only has good flexibility, but also has high thermal conductivity, which helps improve overall performance of the housing 21. In another embodiment, the second layer 12 may be made of another metal, for example, steel or an alloy. A specific material for the second layer 12 is not limited in this application. The first layer 11 is made of a bendable material like a polyimide film (polyimide film, PI), a polypropylene film, a nylon film, a graphite film, or a graphene film. For example, the first layer 11 is a nylon layer, and the second layer 12 is copper foil. Alternatively, the first layer 11 is a nylon layer, and the second layer 12 is aluminum foil. Alternatively, the first layer 11 is a polyimide film, and the second layer 12 is copper foil.

In this embodiment, when a material for the first layer 11 includes a polymer, the first layer 11 is a polymer film layer; and when a material for the second layer 12 includes a metal, the second layer 12 is metal foil, to improve overall flexibility of the housing 21. A specific material, thickness, and the like for the first layer 11 or the second layer 12 are not limited in this application, but can be limited by a person skilled in the art according to an actual requirement.

Still refer to FIG. 6. The accommodation groove 214 is recessed from the outer surface of the housing 21 to the second layer 12. That the accommodation groove 214 is recessed to the second layer 12 indicates that a groove depth of the accommodation groove 214 is from an upper surface of the first layer 11 to an upper surface of the second layer 12. It may be understood that a bottom wall of the accommodation groove 214 is a surface that is of the second layer 12 and that is close to the first layer 11.

In this embodiment, the accommodation groove 214 is recessed from the outer surface of the housing 21 to the second layer 12, the second layer 12 is made of the metal material, a groove wall of the accommodation groove 214 is the second layer 12 made of the metal material, and the heating element 10 is in direct or indirect contact with the second layer 12 made of the metal material in the housing 21. As the metal has good thermal conductivity, introduction of high thermal resistance by the heating element 10 to the partial polymer layer of the housing 21 is avoided, which greatly reduces equivalent thermal resistance of the housing 21, thereby improving heat dissipation performance of the heat dissipation element 20 for the heating element 10.

In some embodiments, an accommodation groove 214 is provided on an outer surface of the housing 21, a bottom wall of the accommodation groove 214 is the second layer 12, and the second layer 12 is made of a metal material. The metal structure of the inner layer of the housing 21 is exposed, and the exposed metal structure may be used for grounding. How the exposed metal structure of the housing 21 is grounded is not limited in this application, but can be designed by a person skilled in the art according to an actual requirement. For example, the exposed metal structure of the housing 21 may be electrically connected to a ground layer of a circuit board.

As shown in FIG. 6, in some embodiments, the first layer 11 is an outermost layer of the housing 21. The second layer 12 is in contact with the cooling medium 22. It may be understood that an innermost layer of the housing 21 is made of a metal material. For example, a material for the first layer 11 includes a polymer, a material for the second layer 12 includes a metal, and thermal conductivity of the material for the first layer 11 is less than thermal conductivity of the material for the second layer 12.

In this embodiment, the innermost layer of the housing 21 is made of the metal material, to isolate the first layer 11 made of the polymer from the cooling medium 22, so that penetration of gaseous or liquid small molecules of the cooling medium 22 into the first layer 11 is avoided in a long-term use process of the heat dissipation element 20, which helps prolong a service life of the heat dissipation element 20.

In some embodiments, the housing 21 further includes an adhesive layer 13. The adhesive layer 13 is bonded between the second layer 12 and the first layer 11. The adhesive layer 13 may be solid glue or liquid glue. A material for the adhesive layer 13 is not limited in this application.

In this embodiment, the first layer 11 and the second layer 12 are fixedly connected by using the adhesive layer 13. In another embodiment, the adhesive layer 13 may be disposed between the first layer 11 and the second layer 12. For example, the first layer 11 and the second layer 12 may be formed by electroplating, electroless plating, spraying, or injection molding. In some other embodiments, the second layer 12 and the first layer 11 may be laminated by vacuum hot rolling, vacuum cold rolling, vacuum diffusion welding, or the like, to form a composite layer. A specific formation process of the housing 21 is not limited in this application, but can be designed by a person skilled in the art according to an actual requirement.

Still refer to FIG. 6. The housing 21 further includes a packaging edge 213. The packaging edge 213 is connected between the first housing 211 and the second housing 212 in a sealed manner. The first housing 211, the second housing 212, and the packaging edge 213 together form the housing 21. A material for the packaging edge 213 includes a material for an innermost structure of the first housing 211 and a material for an innermost structure of the second housing 212.

In this embodiment, the innermost layer of the housing 21 is made of a metal material, and the first housing 211 and the second housing 212 may be packaged by soldering. In this case, the material for the packaging edge 213 is a metal material. It may be understood that the packaging edge 213 is solder for soldering the first housing 211 and the second housing 212. The material for the packaging edge 213 may be, but is not limited to, copper paste, aluminum paste, or the like.

In some other embodiments, when the innermost layer of the housing 21 is made of a polymer material, the first housing 211 and the second housing 212 may be packaged by hot pressing. In this case, the material for the packaging edge 213 is a polymer material.

In some other embodiments, an adhesive is used for the packaging edge 213. It may be understood that the first housing 211 and the second housing 212 are in a sealed connection in an adhesion manner. The adhesive is a technology in which surfaces of homogeneous or heterogeneous substances are bonded together, and is characterized by continuous stress distribution, light weight, sealing, low temperature of most processes, and the like. A specific type of the adhesive is not limited in this application. A person skilled in the art can select a proper adhesive according to an actual requirement. For example, the adhesive may be, based on a form, a water-soluble adhesive, a water-emulsion adhesive, a solvent-based adhesive, or a solid-state adhesive.

In some embodiments, a packaging temperature at which the first housing 211, the second housing 212, and the packaging edge 213 are packaged to form the sealed cavity is less than or equal to 300 degrees. For example, the first housing 211 and the second housing 212 form the sealed cavity by using a hot pressing, soldering, or adhesion process.

In this embodiment, an excessively high packaging temperature is not suitable for the housing 21. For example, the packaging temperature is less than or equal to 300 degrees, to avoid deformation or decomposition of the first layer 11 made of a polymer material due to the excessively high packaging temperature, thereby improving packaging reliability of the housing 21. In addition, an excessively low packaging temperature is not suitable for the housing 21, to avoid a sealing failure of the first housing 211 and the second housing 212 caused by low temperature. A specific packaging temperature for the first housing 211 and the second housing 212 is not limited in this application, but can be designed by a person skilled in the art according to an actual requirement.

It may be understood that a specific process and process parameter for packaging the first housing 211 and the second housing 212 are not limited in this application, but can be designed by a person skilled in the art according to an actual requirement. For example, the first housing 211 and the second housing 212 may be connected by using a hot pressing, adhesion, or soldering process, to avoid deformation of the housing 21 during vacuumizing and working.

Still refer to FIG. 6. The heat dissipation element 20 further includes a liquid-absorbing layer 23 and a channel layer 24. The liquid-absorbing layer 23 and the channel layer 24 are accommodated in the sealed cavity. The liquid-absorbing layer 23 and the channel layer 24 are stacked, and the liquid-absorbing layer 23 is closer to the accommodation groove 214 than the channel layer 24. The liquid-absorbing layer 23 is closer to the accommodation groove 214 than the channel layer 24, that is, the liquid-absorbing layer 23 is closer to the heat source, and is configured to absorb the liquid cooling medium 22 to the housing 21 close to a side of the accommodation groove 214. The channel layer 24 is configured for the cooling medium 22 in a gas phase or a liquid phase to flow.

In an embodiment of this application, the liquid-absorbing layer 23 can generate a capillary force to transport the cooling medium 22, and the cooling medium 22 in the liquid phase flows back to an end close to the heating element 10 with the help of an adsorption force of the liquid-absorbing layer 23. This process is repeated in the sealed cavity to dissipate heat of the heating element 10, to complete an entire power cycle and then complete a thermodynamic cycle.

In some embodiments, the liquid-absorbing layer 23 may be a porous liquid-absorbing core. A material for the liquid-absorbing layer 23 may be, but is not limited to, a bendable hydrophilic material like copper, modified hydrophilic nylon, carbon fiber, graphene fiber, graphene oxide, or polypropylene. A liquid-absorbing layer 23 structure may be formed by 1 to 10 layers of two-dimensional woven mesh, or may be formed by a three-dimensional woven belt, or may be formed by a composite structure of two-dimensional woven mesh and a three-dimensional woven belt. This is not limited in this application. For example, the liquid-absorbing layer 23 is a copper mesh liquid-absorbing core.

In some embodiments, the channel layer 24 may be macroporous mesh, or may be a flexible sheet having a microchannel structure, or may be a microstructure that is bonded to an inner side of the housing 21 by curing polymer precursor liquid glue. For example, the channel layer 2 may be manufactured through laser cutting, wire-electrode cutting, etching, flexible sheet stamping, or a like process. The channel layer 24 is a nylon mesh vapor channel. The channel layer 24 may be connected to the liquid-absorbing layer 23 and the inner side of the housing 21 through a process, for example but not limited to, adhesion, hot pressing, or sintering.

A quantity of layers of the liquid-absorbing core or the channel layer 24 is not limited in this application, but can be designed by a person skilled in the art according to an actual situation. For example, the liquid-absorbing layer 23 is a three-layer super-hydrophilic copper mesh liquid-absorbing core, and the channel layer 24 is single-layer 20-mesh nylon mesh.

In embodiments provided in this application, specific materials for the liquid-absorbing layer 23 and the channel layer 24 are not limited, but can be designed by a person skilled in the art according to an actual requirement. The channel layer 24 can support the housing 21, to avoid deformation of the housing 21 under an external force, which causes the liquid-absorbing layer 23 to be flattened and therefore the heat dissipation element 20 to fail.

In some embodiments, a manufacturing process of the housing 21 may include the following steps: The liquid-absorbing layer 23 and the channel layer 24 are neatly placed inside an aluminum-plastic film housing 21. The aluminum-plastic film housing 21 is packaged from all sides by hot pressing, and a liquid inj ection pipe is inserted. Parameters for the hot pressing process include a temperature of 180 degrees and a pressure of 2 MPa. A polypropylene layer at an inner layer of the housing 21 is melted under a high-temperature and high-pressure condition and then bonded together, to form the packaging edge 213. The packaging of the housing 21 is completed after cooling. The cooling medium 22 is poured into the inside of the aluminum-plastic film housing 21 through a pouring pipe. The aluminum-plastic film housing 21 is vacuumized to make an atmospheric pressure inside lower than 1 Pa and is then sealed. The liquid injection pipe is removed. The first layer 11 and the adhesive layer 13 that are on an outer side of the aluminum-plastic film housing 21 are removed by using a laser processing process, so that the second layer 12 can be in direct contact with a heat source, to form a low-thermal resistance housing 21, thereby improving heat dissipation performance of a flexible heat dissipation element 20.

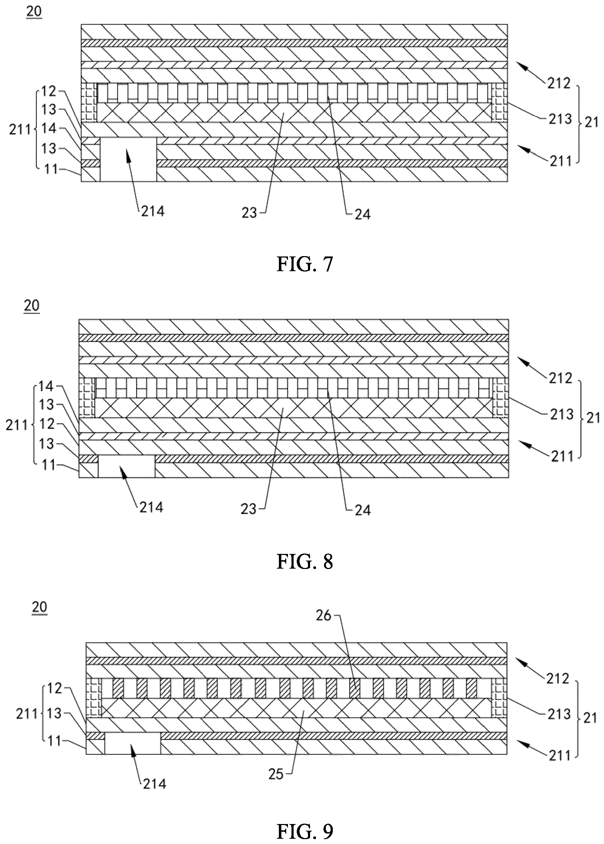

FIG. 7 is a schematic diagram of a cross section of the heat dissipation element 20 shown in FIG. 4 along the line A-A in a second embodiment. This embodiment includes most technical features of the foregoing embodiments, and content of most technical solutions in this embodiment below that are the same as those in the foregoing embodiments is not described again. For example, the housing 21 in the heat dissipation element 20 includes the first layer 11 and the second layer 12, the second layer 12 is closer to the cooling medium 22 than the first layer 11, and a material for the second layer 12 includes a metal. The accommodation groove 214 is provided on a part of the housing 21, the accommodation groove 214 is recessed from an outer surface of the housing 21 to the second layer 12, and the accommodation groove 214 is for accommodating a heating element 10.

In this embodiment, the housing 21 further includes a third layer 14. The third layer 14 is located between the first layer 11 and the second layer 12. A material for the third layer 14 includes a polymer or a metal. The material for the third layer 14 is different from the material for the adjacent first layer 11 or second layer 12.

For example, the second layer 12 is made of a metal material, the third layer 14 is made of a plastic material, and the first layer 11 is made of a metal material. When the material for the first layer 11 includes a metal, the metal material for the first layer 11 may be the same as the metal material for the second layer 12, or may be different from the metal material for the second layer 12. This is not strictly limited in this application. Alternatively, the second layer 12 is made of a metal material, the third layer 14 is made of a first plastic material, the first layer 11 is made of a second plastic material, and the first plastic material is different from the second plastic material.

In this embodiment, the second layer 12 is the innermost structure of the housing 21, and the second layer 12 is made of the metal material to isolate another structure that is of the housing 21 and that is made of a polymer from the cooling medium 22, for example, isolate the third layer 14 from the cooling medium 22, so that penetration of gaseous or liquid small molecules of the cooling medium 22 into the first layer 11 is avoided in a long-term use process of the heat dissipation element 20, which helps prolong a service life of the heat dissipation element 20.

It may be understood that, in this embodiment, the accommodation groove 214 is recessed from the outer surface of the housing 21 to a metal layer (the second layer 12) of the innermost layer of the housing 21. In another embodiment, based on a layer structure design of the housing 21, the accommodation groove 214 may alternatively be recessed from the outer surface of the housing 21 to another layer structure of the housing 21. This is not strictly limited in this application. A person skilled in the art can design a groove depth of the accommodation groove 214 according to an actual situation of the housing 21, to improve heat dissipation performance of the heat dissipation element 20 for the heating element 10.

For example, the first layer 11 is fixedly connected to the third layer 14 by using the adhesive layer 13, and the third layer 14 is fixedly connected to the second layer 12 by using the adhesive layer 13. In another embodiment, the first layer 11 and the third layer 14 or the third layer 14 and the second layer 12 are alternatively fixedly connected in another manner. This is not limited in this application.

In some embodiments, the first housing 211 and the second housing 212 are packaged by soldering. In this embodiment, the second layer 12 made of a metal material is the innermost layer of the first housing 211 and the second housing 212. The metal is packaged by soldering, which helps improve a sealing property of packaging the first housing 211 and the second housing 212. A packaging temperature for soldering is less than or equal to 300 degrees. A person skilled in the art can select parameters of a soldering process based on a material for the innermost layer of the first housing 211 or the second housing 212. This is not strictly limited in this application.

In this embodiment, an excessively high packaging temperature is not suitable for the housing 21. For example, the packaging temperature is less than or equal to 300 degrees, to avoid deformation or decomposition of the layer structure made of a polymer material due to the excessively high packaging temperature for soldering, thereby improving packaging reliability of the housing 21. In addition, an excessively low packaging temperature is not suitable for the housing 21, to avoid a sealed soldering failure of the first housing 211 and the second housing 212 caused by low temperature. A specific packaging temperature for the first housing 211 and the second housing 212 is not limited in this application, but can be designed by a person skilled in the art according to an actual requirement. In another embodiment, the first housing 211 and the second housing 212 may alternatively be packaged in another manner, for example, an adhesion process or a soldering process. This is not limited in this application.

In another embodiment, the housing 21 may further include a fourth layer, and the fourth layer, the first layer 11, the second layer 12, and the third layer 14 are stacked. For example, the fourth layer is also located on a side between the first layer 11 and the second layer 12, and a material for the fourth layer is different from the material for the third layer 14. In this case, the third layer 14 may alternatively be made of a metal material, and the fourth layer is made of a polymer material. It may be understood that a specific quantity of layers of the housing 21 and a specific material for each layer are not limited in this application, but can be designed by a person skilled in the art according to an actual requirement.

FIG. 8 is a schematic diagram of a cross section of the heat dissipation element 20 shown in FIG. 4 along the line A-A in a third embodiment. This embodiment includes most technical features of the foregoing embodiments, and content of most technical solutions in this embodiment below that are the same as those in the foregoing embodiments is not described again. For example, the housing 21 in the heat dissipation element 20 includes the first layer 11 and the second layer 12, the second layer 12 is closer to the cooling medium 22 than the first layer 11, and a material for the second layer 12 includes a metal. The accommodation groove 214 is provided on a part of the housing 21, the accommodation groove 214 is recessed from an outer surface of the housing 21 to the second layer 12, and the accommodation groove 214 is for accommodating a heating element 10.

In this embodiment, the housing 21 further includes a third layer 14. The third layer 14 is located on a side that is of the second layer 12 and that is away from the first layer 11, and a material for the third layer 14 includes a polymer. In other words, the second layer 12 is located between the first layer 11 and the third layer 14. The first layer 11 may be made of a metal material or may be made of a polymer material. This is not limited in this application. When the material for the first layer 11 includes a metal, the metal material for the first layer 11 may be the same as the metal material for the second layer 12, or may be different from the metal material for the second layer 12. This is not strictly limited in this application.

In this embodiment, the second layer 12 (the metal layer) is located in a middle layer of the housing 21, and the accommodation groove 214 is recessed from the outer surface of the housing 21 to the second layer 12 of the housing 21. It may be understood that a person skilled in the art can design a groove depth of the accommodation groove 214 according to a layer structure of the housing 21, so that a layer structure of a bottom wall of the accommodation groove 214 is made of a metal material, to improve heat dissipation performance of the heat dissipation element 20 for the heating element 10.

In some embodiments, the first layer 11 is fixedly connected to the third layer 14 by using the adhesive layer 13, and the third layer 14 is fixedly connected to the second layer 12 by using the adhesive layer 13. For example, the housing 21 is an aluminum-plastic film, and the housing 21 sequentially includes a nylon layer (the first layer 11), the adhesive layer 13, aluminum foil (the third layer 14), the adhesive layer 13, and a polypropylene layer (the second layer 12) from outside to inside. The liquid-absorbing layer 23 located on the inner side of the housing 21 is a three-layer super-hydrophilic copper mesh liquid-absorbing core, and the channel layer 24 is single-layer 20-mesh nylon mesh.

In some embodiments, the first housing 211 and the second housing 212 are packaged by hot pressing. A packaging temperature for hot pressing is less than or equal to 300 degrees. A person skilled in the art can select parameters of a hot pressing process based on a material for the innermost layer of the first housing 211 or the second housing 212. This is not strictly limited in this application. For example, parameters for the hot pressing process include a temperature of 180 degrees and a pressure of 2 MPa, so that the polypropylene layer at the innermost layer (the third layer 14) of the housing 21 is melted under a high-temperature and high-pressure condition and then bonded together, to form the packaging edge 213. The packaging of the housing 21 is completed after cooling.

In this embodiment, an excessively high packaging temperature is not suitable for the housing 21. For example, the packaging temperature is less than or equal to 300 degrees, to avoid deformation or decomposition of the layer structure made of a polymer material due to the excessively high packaging temperature, thereby improving packaging reliability of the housing 21. In addition, an excessively low packaging temperature is not suitable for the housing 21, to avoid a sealed soldering failure of the first housing 211 and the second housing 212 caused by low temperature.

FIG. 9 is a schematic diagram of a cross section of the heat dissipation element 20 shown in FIG. 4 along the line A-A in a fourth embodiment. This embodiment includes most technical features of the foregoing embodiments, and content of most technical solutions in this embodiment below that are the same as those in the foregoing embodiments is not described again. For example, the housing 21 in the heat dissipation element 20 includes the first layer 11 and the second layer 12, the second layer 12 is closer to the cooling medium 22 than the first layer 11, and a material for the second layer 12 includes a metal. The accommodation groove 214 is provided on a part of the housing 21, the accommodation groove 214 is recessed from an outer surface of the housing 21 to the second layer 12, and the accommodation groove 214 is for accommodating a heating element 10.

In this embodiment, the heat dissipation element 20 further includes a capillary structure 25 and a medium channel 26. Both the capillary structure 25 and the medium channel 26 are located in the sealed cavity. The capillary structure 25 is fixed on the first housing 211, and the accommodation groove 214 is located on the first housing 211. One end of the medium channel 26 abuts against the second housing 212, and the other end of the medium channel 26 overlaps the capillary structure 25.

In an embodiment of this application, the capillary structure 25 is fixed on the first housing 211, and the accommodation groove 214 is located on the first housing 211. In other words, the capillary structure 25 is close to the heating element 10. The capillary structure 25 can generate a capillary force to transport the cooling medium 22, and the cooling medium 22 in the liquid phase flows back to an end close to the heating element 10 with the help of an adsorption force of the capillary structure 25. This process is repeated in the sealed cavity to dissipate heat of the heating element 10, to complete an entire power cycle and then complete a thermodynamic cycle.

In addition, the medium channel 26 abuts against the housing 21. The medium channel 26 can be configured to resist deformation of the heat dissipation element 20 caused by an internal and external atmospheric pressure difference and another external force, to maintain a shape of the housing 21 and avoid deformation of the housing 21 under an external force, which causes the capillary structure 25 to be flattened and therefore the heat dissipation element 20 to fail. For example, the medium channel 26 is formed by a plurality of support columns disposed at intervals, and a channel between the support columns is a cooling medium 22 channel and/or forms the capillary structure 25.

In some embodiments, the medium channel 26 is fixed on the innermost side of the housing 21 in an adhesion manner. A specific manner of forming the medium channel 26 is not limited in this application, but can be designed by a person skilled in the art according to an actual situation. For example, the medium channel 26 is a microstructure formed by curing polydimethylsiloxane (polydimethylsiloxane, PDMS).

In some embodiments, a manufacturing process of the housing 21 may include the following steps: Polydimethylsiloxane liquid glue is cured on the inner side of the housing 21 to obtain a microstructure to form the medium channel 26. The capillary structure 25 and a hot-melt adhesive stick are neatly placed inside the housing 21. The first housing 211 and the second housing 212 are packaged from all sides by hot pressing, and a liquid injection pipe is inserted. Parameters for the hot pressing process include a temperature of 160 degrees and a pressure of 1 MPa, so that the hot-melt adhesive stick is melted under a high-temperature and high-pressure condition and then bonded together, to form the packaging edge 213. The packaging of the housing 21 is completed after cooling. A deionized water working medium is poured into the inside of the housing 21 through a pouring pipe. The housing 21 is vacuumized to make an atmospheric pressure inside lower than 1 Pa and is then sealed. The liquid injection pipe is removed. The first layer 11 and the adhesive layer 13 that are on an outer side of the housing 21 are removed by using a laser processing process, so that the second layer 12 (the metal layer) can be in direct contact with the heating element 10, to form a low-thermal resistance housing 21, thereby improving heat dissipation performance of the heat dissipation element 20.

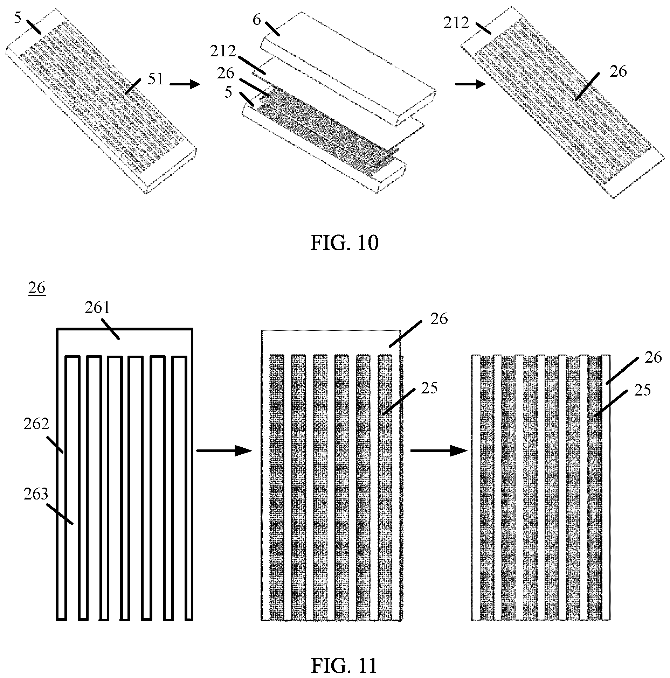

FIG. 10 is a schematic diagram of a structure of the medium channel 26 in FIG. 9 formed in an implementation. In some embodiments, a surface of a metal sheet is processed through etching, laser processing, electrical discharge machining, micro-milling, or a like process to obtain a micro-groove structure, to form a cured mold 5. A micro-groove array 51 is provided on a surface of the mold 5. Polydimethylsiloxane precursor liquid glue is mixed in a specific ratio and then scrape-coated or spin-coated in the micro groove 51 on the surface of the mold 5. Then, the second housing 212 is horizontally attached to the surface of the mold 5 and pressed tightly by using a flat plate 6. The mold 5, the flat plate 6, and the second housing 212 are baked in an oven. After cooling, microchannels formed by a plurality of medium channels 26 obtained by curing polydimethylsiloxane are obtained on the inner side of the second housing 212. A thickness of the metal sheet is not limited. For example, the metal sheet is a copper sheet with a thickness of 1 mm.

FIG. 11 is a schematic diagram of a structure of the medium channel 26 in FIG. 9 formed in another implementation. The medium channel 26 is a flexible sheet having microchannels. For example, on the medium channel 26, polyethylene terephthalate (polyethylene terephthalate, PET) is processed by using a laser processing process to form a microchannel 263, and simultaneously forms a microchannel connection structure 261 and a microchannel spacing structure 262. Then, the capillary structure 25 and the medium channel 26 are connected by using a glue adhesion process. Finally, the microchannel connection structure 261 is removed to form a gas-liquid integrated liquid-absorbing core. Other process steps for forming the housing 21 in this embodiment are the same as those in the foregoing embodiments, and details are not described herein again.

In another embodiment, the medium channel 26 may be formed first, and then the medium channel 26 is filled with the capillary structure 25, to implement thickness reuse of the medium channel 26 and the capillary structure 25. A process for forming the capillary structure 25 and the medium channel 26 is not limited in this application, but can be designed by a person skilled in the art based on the conventional technology.

In some other embodiments, the medium channel 26 and the second housing 212 are integrally formed. In this embodiment, the medium channel 26 and the second housing 212 are integrally formed, thereby simplifying a forming process of the heat dissipation element 20. It may be understood that a process for forming the medium channel 26 and the housing 21 is not limited in this application, but can be designed by a person skilled in the art according to an actual situation.

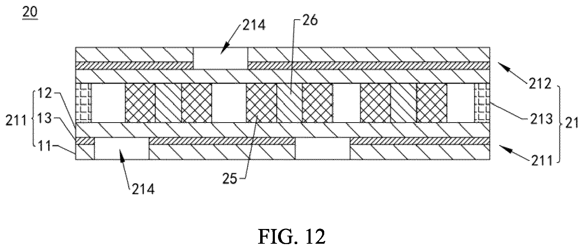

FIG. 12 is a schematic diagram of a cross section of the heat dissipation element 20 shown in FIG. 4 along the line A-A in a fifth embodiment. This embodiment includes most technical features of the foregoing embodiments, and content of most technical solutions in this embodiment below that are the same as those in the foregoing embodiments is not described again. For example, the housing 21 in the heat dissipation element 20 includes the first layer 11 and the second layer 12, the second layer 12 is closer to the cooling medium 22 than the first layer 11, and a material for the second layer 12 includes a metal. The accommodation groove 214 is provided on a part of the housing 21, the accommodation groove 214 is recessed from an outer surface of the housing 21 to the second layer 12, and the accommodation groove 214 is for accommodating a heating element 10.

In this embodiment, the heat dissipation element 20 further includes a capillary structure 25 and a medium channel 26. Both the capillary structure 25 and the medium channel 26 are located in the sealed cavity. One end of the capillary structure 25 is connected to the first housing 211, and the other end is connected to the second housing 212. The medium channel 26 is connected to the capillary structure 25, one end of the medium channel 26 is connected to the first housing 211, and the other end is connected to the second housing 212. It may be understood that the capillary structure 25 is embedded in the medium channel 26.

In this embodiment, the capillary structure 25 is embedded in the medium channel 26, the capillary structure 25 and the medium channel 26 form an integral structure, and the capillary structure 25 and the medium channel 26 are reused in a thickness direction of the housing 21, which reduces a thickness of the entire heat dissipation element 20, thereby reducing a thickness of an entire electronic device 100.

A manufacturing process of the capillary structure 25 and the medium channel 26 is not limited in this application, but can be designed by a person skilled in the art according to an actual situation.

Still refer to FIG. 12. There are a plurality of accommodation grooves 214, and the plurality of accommodation grooves 214 are provided at intervals. Both the first housing 211 and the second housing 212 are provided with the accommodation groove 214. As shown in FIG. 12, for example, the first housing 211 is provided with two accommodation grooves 214, and the second housing 212 is provided with one accommodation groove 214.

In this embodiment, the capillary structure 25 is embedded in the medium channel 26, and the capillary structure 25 is connected to both the first housing 211 and the second housing 212. The cooling medium 22 in the liquid phase can flow back to the inner side of the first housing 211 or the inner side of the second housing 212 with the help of an adsorption force of the capillary structure 25, to effectively dissipate heat of the heating element in the accommodation groove 214 of the first housing 211 and the heating element in the accommodation groove 214 of the second housing 212, to complete an entire power cycle and then complete a thermodynamic cycle. In another embodiment, the accommodation groove 214 may be located only on the first housing 211 or the second housing 212. This is not strictly limited in this application.

The foregoing descriptions are merely specific implementations of this application, but are not intended to limit the protection scope of this application. Any variation or replacement readily figured out by a person skilled in the art within the technical scope disclosed in this application shall fall within the protection scope of this application. If there is no conflict, embodiments of this application and the features in the embodiments may be combined with each other. Therefore, the protection scope of this application shall be subject to the protection scope of the claims.

## Claims

1. A heat dissipation element, comprising a housing and a cooling medium located on an inner side of the housing, wherein the housing is sealed to form a sealed cavity, and the cooling medium is located in the sealed cavity;
the housing comprises a first layer and a second layer, a material for the first layer comprises a polymer, a material for the second layer comprises a metal, and the second layer is closer to the cooling medium than the first layer; and
an accommodation groove is provided on a part of the housing, the accommodation groove is recessed from an outer surface of the housing to the second layer, and the accommodation groove is for accommodating a heating element.

2. The heat dissipation element according to claim 1, wherein the first layer is an outermost layer of the housing, and the second layer is in contact with the cooling medium.

3. The heat dissipation element according to claim 2, wherein the housing further comprises a third layer, the third layer is located between the first layer and the second layer, and a material for the third layer comprises a polymer or a metal.

4. The heat dissipation element according to claim 1, wherein the housing further comprises a third layer, the third layer is located on a side that is of the second layer and that is away from the first layer, and a material for the third layer comprises a polymer.

5. The heat dissipation element according to any one of claims 1 to 4, wherein the housing comprises a first housing, a second housing, and a packaging edge, wherein the packaging edge is connected between the first housing and the second housing in a sealed manner, and a material for the packaging edge comprises a material for an innermost structure of the first housing and a material for an innermost structure of the second housing; or an adhesive is used for the packaging edge.

6. The heat dissipation element according to claim 5, wherein the heat dissipation element further comprises a liquid-absorbing layer and a channel layer, wherein the liquid-absorbing layer and the channel layer are accommodated in the sealed cavity, the liquid-absorbing layer and the channel layer are stacked, and the liquid-absorbing layer is closer to the accommodation groove than the channel layer.

7. The heat dissipation element according to claim 5, wherein the heat dissipation element further comprises a capillary structure and a medium channel, wherein both the capillary structure and the medium channel are located in the sealed cavity, the capillary structure is fixed on the first housing, and the accommodation groove is located on the first housing; and one end of the medium channel abuts against the second housing, and the other end of the medium channel overlaps the capillary structure.

8. The heat dissipation element according to claim 5, wherein the heat dissipation element further comprises a capillary structure and a medium channel, wherein both the capillary structure and the medium channel are located in the sealed cavity, one end of the capillary structure is connected to the first housing, the other end is connected to the second housing, the medium channel is connected to the capillary structure, one end of the medium channel is connected to the first housing, and the other end is connected to the second housing.

9. The heat dissipation element according to claim 8, wherein there are a plurality of accommodation grooves, the plurality of accommodation grooves are provided at intervals, and both the first housing and the second housing are provided with the accommodation grooves.

10. The heat dissipation element according to claim 5, wherein a packaging temperature at which the first housing, the second housing, and the packaging edge are packaged to form the sealed cavity is less than or equal to 300 degrees.

11. An electronic device, comprising a heating element and the heat dissipation element according to any one of claims 1 to 10, wherein at least a part of a structure of the heating element is accommodated in the accommodation groove, and the heat dissipation element is configured to dissipate heat of the heating element.

12. The electronic device according to claim 11, wherein the electronic device comprises a first outer shell and a second outer shell that are connected to each other, wherein the second outer shell is capable of being bent relative to the first outer shell, and the heating element is accommodated in the first outer shell; and the heat dissipation element comprises a first section and a second section that are integrally formed, the first section is accommodated in the first outer shell, the second section is accommodated in the second outer shell, and the second section is capable of being bent relative to the first section.

13. The electronic device according to claim 12, wherein the electronic device further comprises a third outer shell, the third housing is located on a side that is of the first housing and that is away from the second housing, and the third outer shell is capable of being bent relative to the first outer shell; and the heat dissipation element further comprises a third section, the third section is accommodated in the third outer shell, the third section is connected to an end that is of the first section and that is away from the second section, the third section and the first section are integrally formed, and the third section is capable of being bent relative to the first section.

14. The electronic device according to any one of claims 11 to 13, wherein the electronic device further comprises a thermal interface layer, the thermal interface layer is connected between the second layer and the heating element, and a material for the thermal interface layer comprises a thermal interface material.

15. The electronic device according to claim 14, wherein the electronic device further comprises a circuit board and a shielding cover, wherein the heating element is mounted on the circuit board, the shielding cover is disposed around a periphery of the heating element and forms, with the circuit board, shielding space, and the heating element is accommodated in the shielding space.

16. The electronic device according to claim 15, wherein a first thermal interface layer and a second thermal interface layer are comprised between the heating element and the heat dissipation element, the first thermal interface layer is located between the shielding cover and the heating element, the second thermal interface layer is located between the heat dissipation element and the shielding cover, and both the first thermal interface layer and the second thermal interface layer are made of the thermal interface material.
